Europäisches Patentamt

European Patent Office

Office européen des brevets

(11) Publication number: **0 210 582 B1**

# EUROPEAN PATENT SPECIFICATION

(45) Date of publication of patent specification: **27.02.91**   (51) Int. Cl.⁵: **G11B 7/12**

(21) Application number: **86110085.7**

(22) Date of filing: **22.07.86**

(54) **Optical head apparatus.**

(30) Priority: **29.07.85 JP 167010/85**
**29.07.85 JP 167011/85**

(43) Date of publication of application:
**04.02.87 Bulletin  87/06**

(45) Publication of the grant of the patent:
**27.02.91 Bulletin  91/09**

(84) Designated Contracting States:
**DE FR GB**

(56) References cited:
**EP-A- 0 171 929**
**EP-A- 0 183 046**
**DE-A- 3 017 481**
**US-A- 4 333 173**

(73) Proprietor: **MITSUBISHI DENKI KABUSHIKI
KAISHA
2-3, Marunouchi 2-chome Chiyoda-ku
Tokyo 100(JP)**

(72) Inventor: **Shikama, Shinsuke
Eiichi Toide Mitsushige Kondou Babazusho
1
Nagaokakyo-shi Kyoto-fu 617(JP)**
Inventor: **Iwata, Kazuo
Ooaza Iwamatsu 800 Ojima-machi
Nitta-gun Gunma-ken 370-04(JP)**

(74) Representative: **Goddar, Heinz J., Dr. et al
FORRESTER & BOEHMERT Widenmayer-
strasse 4/I
D-8000 München 22(DE)**

## Description

The present invention relates to an optical head apparatus in which data may stored on and read from an optical storage media, and more particularly to a system which employs a so-called twin-spot method as a track displacement detection technique for scanning data tracks of such optical storage means.

Earlier European application EP-A-l71 929 falling under Art.54(3) already describes an optical head apparatus having a light source mounted on a base element containing a mount in, a manner that a light emitting end face of said light source is made flush with a front end face of said base element; optical incident means for diffracting a light beam emitted from said light source into a plurality of diffracted light beams and for focusing said diffracted light beams to a plurality of spot lights on a data storage media; splitter means interposed in said optical incident means, for separating light beams coming from the side of said light source from reflected light beams coming from said data storage media; and photodetection means constructed of a plurality of photoreceptors for receiving light beams having been separated by said splitter means, whereby a light beam treating means is provided in a portion of said base element on which portion re-incident light beams not having been separated by said splitter means are incident again, said light beam treating means preventing said re-incident light beams from being reflected toward said optical incident means, said light beam treating means being constructed of a serrated surface formed in said front end face of said base element for reflecting the incident light beams out of said optical incident means.

In this apparatus the light treating means is constructed as an oblique, rough surface, which causes an irregular reflection of the light beam incident on the front end face of the mount or the buffer layer, resp.

It is the object of the invention to provide an optical head apparatus in which the oblique surfaces causes a regular reflection of the light beam.

According to the invention this object is solved in that said serrated surface comprises a plurality of small oblique faces each of which crosses a vertical plane at an angle of ⊖ so that the light beam incident on the front end face of said mount or the front end face of said buffer layer is reflected in a direction deviated by an angle of 2 ⊖ from the light path of such incident beam.

The present invention will become more apparent from the following detailed description in conjunction with the drawings, in which:

Fig. 1　is a schematic view of the LD chip employed in a first embodiment of the invention, and

Fig. 2　is a schematic view of the LD Chip employed in a second embodiment of the invention.

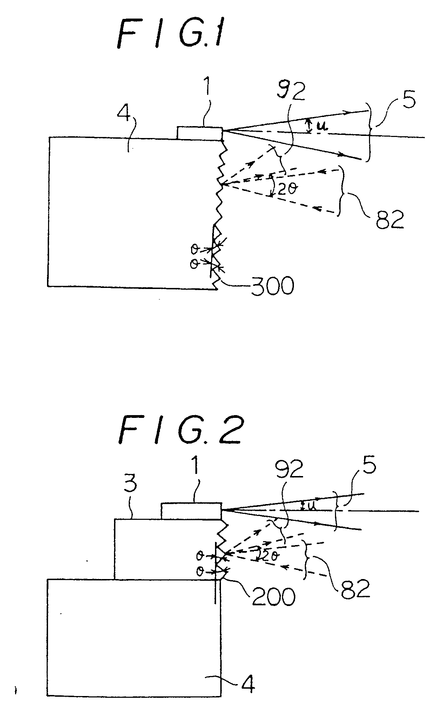

In Fig. 1 the light treating means is constructed of a serrated surface formed in the front end face 300 of mount 4, which serrated surface comprises a plurality of small oblique faces each of which crosses a vertical plane at an angle of ⊖, so that the light beam incident on the front end face 300 of the mount 4 is reflected in a direction deviated by an angle of 2 ⊖ from the light path of such incident beam to make it possible to eliminate/reduce the interference.

The first order light beam 82 having been reflected form the disk (not shown) toward the side of the LD chip 1 is reflected from the front end face 300 of the mount 4 in a direction deviated from the optical axis of such incident beam 82 by an angle of 2 ⊖ to become a light beam 92. Consequently, in case that a half angle if the light beam emitted from the LD chip 1 and to be focused is designated by the reference character u, when the angle of ⊖ is larger than the half angle u, the thus reflected light beam 92 does not pass through the light path of the incident beam 82 at all, to make it possible to prevent the reflected beam 92 from being focused on the the disk by the objective lens (not shown), so that the interference is prevented from occurring. It is naturally possible to decrease the amount of light of the beam 92 returning again to the position of the 1st order light beam on the disk when the angle of ⊖ is slightly smaller than the half angle u. Therefor, in this case, such provisions of the surface formed in the front end face 300 of the mount 4 with a plurality of such oblique faces is advantageous to reduce the influence of the interference.

In Fig. 2 the base element is constructed of said mount 4 and a buffer layer 3. The light treating means is constructed of a serrated surface formed in the front end face 200 of a buffer layer 3, which serrated surface comprises a plurality of small oblique faces each of which crosses a vertical plane at an angle of ⊖, so that the light beam incident on the front end face 200 of the buffer layer 3 is reflected in a direction deviated by an angle of 2 ⊖ from the light path of such incident beam to make it possible to eliminate or to reduce the interference.

## Claims

1. Optical head apparatus having a light source (1) mounted on a base element containing a mount (4) in a manner that a light emitting end face of said light source (1) is made flush with a front end face (300) of said base element or the front end face (200) of a buffer layer (3); optical incident means for diffracting a light beam (5) emitted from said light source (1) into a plurality of diffracted light beams and for focusing said diffracted light beams to a plurality of spot lights on a data storage media; splitter means interposed in said optical incident means, for separating light beams coming from the side of said light source (1) from reflected light beams coming from said data storage media; and photodetection means constructed of a plurality of photoreceptors for receiving light beams having been separated by said splitter means, whereby a light beam treating means is provided in a portion of said base element on which portion re-incident light beams not having been separated by said splitter means are incident again, said light beam treating means preventing said re-incident light beams from being reflected toward said optical incident means, said light beam treating means being constructed of a serrated surface formed in said front end face (300) of said base element (4) or said front end face (200) of said buffer layer (3) for reflecting the incident light beams out of said optical incident means, said serrated surface comprising a plurality of small oblique faces each of which crosses a vertical plane at an angle of $\Theta$ so that the light beam incident on the front end face (300) of the mount (4) or the front end face (200) of said buffer layer (3) is reflected in a direction deviated by an angle of $2\Theta$ from the light path of such incident beam.

**Revendications**

1. Dispositif à tête optique comportant une source lumineuse (1) montée sur un élément de base contenant une monture (4), de façon telle qu'une face d'extrémité, émettant de la lumière, de ladite source lumineuse (1) est placée en affleurement avec une face d'extrémité avant (300) dudit élément de base ou de la face d'extrémité avant (200) d'une couche tampon (3); un moyen d'incidence optique pour diffracter un faisceau lumineux (5) émis par ladite source lumineuse (1) en formant une pluralité de faisceaux lumineux diffractés et pour focaliser lesdits faisceaux lumineux diffractés en formant une pluralité de points lumineux sur un milieu de stockage de données; des moyens de fractionnement interposés dans ledit moyen d'incidence optique pour séparer les faisceaux lumineux provenant du côté de ladite source lumineuse (1) d'avec les faisceaux réfléchis qui viennent dudit moyen de stockage de données; et un moyen de photodétection formé d'une pluralité de photorécepteurs, pour recevoir des faisceaux lumineux ayant été séparés par ledit moyen de fractionnement, un moyen de traitement du faisceau lumineux étant prévu dans une partie dudit élément de base sur laquelle des faisceaux lumineux renvoyés en incidence n'ayant pas été séparés par ledit moyen de fractionnement sont retournés en incidence, ledit moyen de traitement de faisceau lumineux empêchant que lesdits faisceaux lumineux renvoyés en incidence soient réfléchis vers ledit moyen d'incidence optique, ledit moyen de traitement de faisceau lumineux étant constitué par une surface striée formée dans ladite face d'extrémité avant (300) dudit élément de base (4), ou dans ladite face d'extrémité avant (200) de ladite couche tampon (3), pour réfléchir les faisceaux lumineux incidents hors dudit moyen d'incidence optique, ladite surface striée comprenant une pluralité de facettes obliques qui traversent chacune un plan vertical en faisant un angle $\Theta$, de façon que le faisceau de lumière incident sur la face d'extrémité avant (300) de la monture (4) ou sur la face d'extrémité avant (200) dudit revêtement tampon (3) soit réfléchi en une direction déviée d'un angle $2\Theta$ par rapport à la trajectoire lumineuse dudit faisceau incident.

**Ansprüche**

1. Optische Kopfvorrichtung, mit einer Lichtquelle (1), die an einem mit einer Einfassung (4) versehenen Basiselement derart montiert ist, daß eine lichtaussendende Stirnfläche der Lichtquelle (1) mit einer vorderen Stirnfläche (300) des Basiselements oder der vorderen Stirnfläche (200) einer Pufferschicht (3) bündig ist; optischen Auffallmitteln zur Diffraktion eines von der Lichtquelle (1) ausgestrahlten Lichtstrahls (5) in eine Mehrzahl von gebeugten Lichtstrahlen und zum Fokussieren der gebeugten Lichtstrahlen in eine Mehrzahl von Punktlichten auf ein Datenspeichermittel; in den optischen Auffallmitteln angeordneten Spaltmitteln zum Trennen der von der Seite der Lichtquelle (1) kommenden Lichtstrahlen von reflektierten Lichtstrahlen, die von dem Datenspeichermedium kommen; und aus einer Mehrzahl von Photorezeptoren gebildeten Photodetektionsmitteln zum Aufnehmen der Lichtstrahlen, die von den Spaltmitteln getrennt worden sind; wobei Lichtstrahlbehandlungsmittel in einem Abschnitt des Basiselements vorgesehen sind, auf den von den Spaltmitteln nicht getrennte, rück-auffallende Lichtstrahlen wieder auffallen, die Lichtbehandlungsmittel die rück-auffallenden Lichtstrahlen daran hindern, auf die optischen Auffallmittel reflektiert zu werden, die Lichtbehandlungsmittel als eine gekerbte, in der vorderen Stirnfläche (300) des Basiselements (4) oder der vorderen Stirnfläche (200) der Pufferschicht (3) ausgebildete Oberfläche zum Reflektieren der auffallenden Lichtstrahlen aus den optischen Auffallmitteln hinaus ausgebildet ist, die ge kerbte Oberfläche eine Vielzahl von geneigten Flächen aufweist, die jeweils eine vertikale Ebene in einem Winkel von 0 kreuzen, so daß der auf die vordere Stirnfläche (300) der Einfassung (4) oder die vordere Stirnfläche (200) der Pufferschicht (3) auffallende Lichtstrahl in eine Richtung reflektiert wird, der um einen Winkel 2 Θ von dem Lichtweg eines solchen auffallenden Strahls abweicht.

F I G.1

F I G.2